(19) Europäisches Patentamt
European Patent Office
Office européen des brevets

(11) **EP 4 303 907 A1**

(12) **EUROPEAN PATENT APPLICATION**

(43) Date of publication:
**10.01.2024 Bulletin 2024/02**

(21) Application number: **22183392.4**

(22) Date of filing: **06.07.2022**

(51) International Patent Classification (IPC):
**H01J 37/147** (2006.01)   **H01J 1/00** (2006.01)
**H01J 49/00** (2006.01)

(52) Cooperative Patent Classification (CPC):
**H01J 37/1472; H01J 49/22;** H01J 2237/151

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Universität Hamburg
20148 Hamburg (DE)**

(72) Inventors:
- **Drescher, Markus
  21465 Reinbek (DE)**
- **Heyer, Jette
  22763 Hamburg (DE)**
- **Wessels-Staarmann, Philipp
  22559 Hamburg (DE)**

(74) Representative: **Hauck
Patentanwaltspartnerschaft mbB
Postfach 11 31 53
20431 Hamburg (DE)**

(54) **ELECTROSTATIC DEFLECTOR FOR CHARGED PARTICLE OPTICS**

(57)    Electrostatic deflector for charged particle optics comprising at least two deflection electrodes connected to at least one power supply to supply a predefined potential ($U_i$) to at least one of the deflection electrodes, wherein the deflection electrodes define an axis of flight for a charged particle beam and provide an electrical field in a transverse direction to the axis of flight, wherein a central electrode encloses the axis of flight, wherein the central electrode has a plurality of openings through which the electrical field of the deflection electrodes penetrates into the central electrode and deflects the charged particle beam within the central electrode.

Fig. 1

**Description**

The present invention refers to an electrostatic deflector for charged particle optics comprising at least two deflection electrodes.

The electrostatic deflector provides a defined electric field E and a fixed nominal potential $U_{nom}$ in the centre of the deflector as a particle optics system of an instrument. In a case of a conventional deflector this is achieved by connecting all deflecting electrodes to internal power supplies providing all these electrodes with predefined potentials. By supplying all deflecting electrodes with the nominal potential, particles pass the deflector without change of direction. With an anti-symmetric potential difference supplied to opposite deflecting electrodes, an electric field is generated without changing the nominal potential in the centre of the electrode. In order to generate, for example, a field strength of E = 1 V/mm at a nominal potential of 1 kV across a gap of 16 mm, it is necessary to set the opposite electrodes to potentials of 992 V and 1008 V, respectively. Such a configuration would, for example, deflect a beam of protons at 2 keV kinetic energy by an angle of 3.8°. One of the technical problems with this conventional approach is, that the control of the electrostatic deflector requires a high relative accuracy for the provided voltages. For the desired accuracy in a typical application where an angular stability at the level of at least 0.00085° has to be maintained, it is necessary to control the voltage on a scale of 10 mV or better for 1 kV applied to the deflector electrodes. This requires a relative accuracy of $10^{-5}$ which is technically demanding with respect to residual ripple, noise and temperature stability. The purpose of the invention introduced here, is to greatly relax the requirements for the numerous power supplies for deflecting particle optics in terms of their stability and voltage level. Equivalently, with a given set of power supplies, much higher precision in the stability of the deflection can be achieved.

US 10,796,893 B2 discloses RF ion guides and is configured as an array of elongated electrodes arranged symmetrically about a central axis. Voltage is provided to the elongated electrodes for at least a portion of the lengths that is semi-transparent to electric fields. Auxiliary electrodes are then provided proximal to the RF electrodes distal to the ion guide axis, such that application of DC voltage to the auxiliary electrodes causes an auxiliary electric field to form between the auxiliary electrodes and the ion guide RF electrodes. According to this arrangement a portion of this auxiliary electric fields enters through the semi-transparent portions of the RF electrodes, such that the potential within the ion guide is modified. The auxiliary electrode structures and voltages can be configured such that a potential gradient develops along the ion guide axis. The longitudinal potential gradient exerts a force for the charged particle within the beam in the direction of its propagation. For this purpose, the field penetrating through the semi-transparent RF electrodes should be of comparable magnitude as the field between RF electrode and auxiliary electrode. The axial gradient is fixed by the geometry and allows no dynamic modification of the transversal direction of the charged particles so that the beam cannot be steered into a specific direction.

DE 11 2008 003 955 B4 discloses a mass spectrometer having a mesh electrode with cells from 10 $\mu$m to 1 mm. A second electrode is positioned behind the mesh electrode at a distance comparable to a cell size of the mesh electrode. A radio frequency voltage supply is coupled between said mesh electrode and the second electrode to form a substantially symmetric RF field around the mesh electrode.

JPS 57202630 A2 refers to an electrostatic deflector which achieves a low astigmatism in the wide range by splitting the whole cylinder electrode into a specific number of stripes. By splitting the electrode, it is possible to provide a XY deflection by using different electrodes. The hollow cylindrical electrode is split into 12, 20, 28, ... stripes of electrodes with a common central axis for all stripes. The stripes are controlled individually so that high accuracy can be achieved.

JPS 61142646 discloses the focusing and deflecting device for a charged particle beam. To establish focusing and deflecting of charged particle beams a first group of electrodes is grouped for achieving the focussing action and another electrode group for achieving the deflection of the particle beam. Importantly, this invention only allows a deflection in combination with focusing and defocusing of a beam.

The technical problem to be addressed by the invention is to provide an electrostatic deflector which allows deflection with a high degree of accuracy as well as pointingstability over time at low cost.

The problem of the invention is solved by the electrostatic electrodes according to claim 1. Preferred embodiments of the invention are the subject of the independent claims.

The electrostatic deflector according to the invention is suited for charged particle optics. In charged particle optics, beams of charged particles such as protons, electrons, positrons or ions are deflected as they travel in vacuum. The electrostatic deflector comprises at least two deflection electrodes connected to at least one power supply to supply a predefined potential to at least one of the deflection electrodes. That is, at least one of the deflection electrodes is provided with a potential relative to the other electrodes. The deflection electrodes define an axis of flight for the charged particle beam. Furthermore, an electrical field in a transversal direction to the axis of flight is provided. The electrical field is the gradient of the potential.

According to the invention a central electrode encloses the axis of flight. That is, the beam of charged particles travels within the central electrode. The central electrode has a plurality of openings through which the electrical field of the deflection electrode penetrates into the central electrode. The electrical field penetrated into the central electrode deflects the charged particle beam. The central idea of the invention is to deflect the charged particle beam not directly by the electrical field provided by the deflection electrodes but rather by using the penetrating electrical field modified by the openings in the central electrode. Even though a third electrode is introduced into the electrostatic deflector, the penetrated field in the central electrode has a similar distribution compared to the conventional deflector without central electrode, albeit with a significantly reduced strength. Importantly, this suppression of the field strength is essential for reducing the sensitivity of the deflecting structure on voltage fluctuations and voltage drifts by orders of magnitude while maintaining functionality and precise control of the particle deflection within the central electrode.

The preferred embodiment of the deflection electrodes encloses the central electrode. By enclosing the central electrode, the deflection is controlled by the electric field which penetrates radially into the central electrode.

In a preferred embodiment the central electrode is connected to a power supply for applying a predefined potential to the central electrode. Preferably, the potential applied to the central electrode is not used to deflect the charged particles but serves to establish - in combination with the potentials of deflecting electrodes - the desired nominal potential $U_{nom}$ on the axis of the deflector. The force acting on the charged particles is created by the electric field penetrating through the central electrode provided by the gradient of the potential of the deflector electrodes.

The deflection electrodes are formed as a cylinder, preferable a segmented cylinder or a segmented circular cylinder with the particle beam travelling parallelly along the longitudinal axis of the cylinder. Preferably, the cylinder forms a circular cylinder. When stating that the at least two deflection electrodes form a cylinder it is of course included that the at least two deflection electrodes are electrically isolated from the neighbouring electrodes. That means the cylinder is not completely closed but gives sufficient room for an electric isolation.

In a preferred embodiment the at least two deflection electrodes have the same size and form and cover all four quadrants around the central electrode. This means, the electric field of the deflection electrodes penetrates from all directions into the central electrode.

In a preferred embodiment, different modes of operation are defined for the electrostatic deflector. These different modes of operation do not necessarily differ in their accuracy but may differ in the number of power supplies necessary for the electrostatic deflector as well as in the respective voltage levels. With respect to the number of different power supplies it should be noted that a single power supply may supply one, two or more different electric voltages to the electrostatic deflectors. This means, that different voltage values do not necessarily mean different devices for the power supply. Three different modes can be stipulated by the following master equation:

$$U_{j,\mathrm{l,r}} = U_{\mathrm{off}} \pm \Delta U_j, \qquad j = 1, 2, 3$$

wherein j denotes the mode of operation, $U_{j,\mathrm{l,r}}$ the potential of the right and left electrode (r, l) in the j-th mode of operation, if horizontal deflection is considered. $U_{\mathrm{off}}$ denotes an auxiliary common potential for the both electrodes, while $\Delta U_j$ is a common additional potential in the j-th mode of operation that is $U_{\mathrm{off}} + \Delta U_j$ refers to the right electrode and $U_{\mathrm{off}} - \Delta U_j$ refers the left electrode.

In the first mode of operation, the at least two deflection electrodes are supplied with the central electrode potential ($U_c$) superimposed with potentials of the same magnitude ($\Delta U_1$) but opposite sign for opposing deflection electrodes, such that at least one of the deflection electrodes is supplied with a total potential equal to the central electrode potential plus the additional potential and the at least one opposite deflection electrode is supplied with a total potential equal to the central electrode potential minus the additional potential. In the first mode of operation opposing deflection electrode differ plus/minus the additional potential. Using the above master equation, the first mode is characterized such that: $U_c = U_{\mathrm{off}}$. The deflection is controlled precisely by the additional potential which varies in magnitude and sign in order to achieve the desired deflection angle and direction, respectively. In the first mode of operation the nominal potential ($U_{nom}$) along the longitudinal axis of the at least two deflection electrodes is equal to the potential of the central electrode potential ($U_c = U_{nom}$).

In a second mode of operation, the potential of the central electrode is not equal to the nominal potential $U_c \neq U_{nom}$. Instead, one deflection electrode is supplied with a positive potential while the opposite deflection electrode is supplied with a negative potential of the same magnitude $U_{\mathrm{off}} = 0$. Preferably, in the second mode of operation the central electrode is supplied with a potential which is chosen to establish the desired nominal potential on the deflector axis. In this preferred configuration of the second mode of operation opposing deflection electrodes have potentials of opposite sign $U_{2,\mathrm{l,r}} = \pm\Delta U_2$.

In a third mode of operation, the offset potential is adapted in such a way that one of the opposing electrodes is set to zero potential, while the potentials of the opposite electrode and the central electrode are adjusted so as to keep the nominal potential ($0 = U_{\mathrm{off}} - \Delta U_3$). Here, only two potentials need to be applied to the electrostatic deflector. That is one potential to one of the opposing electrodes and one potential to the central electrode.

In a preferred embodiment it is possible for all three modes of operation to provide a compensation voltage to at least one of the deflection electrodes. The compensation voltage is defined such that an off-centre position of the central electrode with respect to the deflecting electrodes is compensated for particle beams passing through the central electrode. The deflection of the electrodes is calculated for a central electrode being precisely within the centre of the deflection electrodes. Due to manufacture, transport and other circumstances the position of the central electrode may vary so that the particular beam gets unintentionally deflected. The idea of the compensation voltage is to compensate the effect of a displaced central electrode by applying an additional deflecting field. Preferably, the corresponding compensation voltage is calibrated using a test beam.

The invention as explained using the following embodiment:

Figure 1     shows the invented electrostatic deflector for electron and ion optics for the particular case of a vertical deflection,

Figure 2     shows a comparison between a conventional 2-dimensional deflector and a field penetrating 2-dimensional deflector according to the invention,

Figure 3     compares the deflection per applied deflection potential for a traditional deflector and the field penetrating deflector,

Figure 4     shows the scaling of the field penetration geometry with the wall thickness and the open area ratio,

Figure 5     shows an example of the potentials for the three modes of operation for one-dimensional steering, and

Figure 6     shows the compensation for a geometrical displacement of the central electrode by an additional deflecting field.

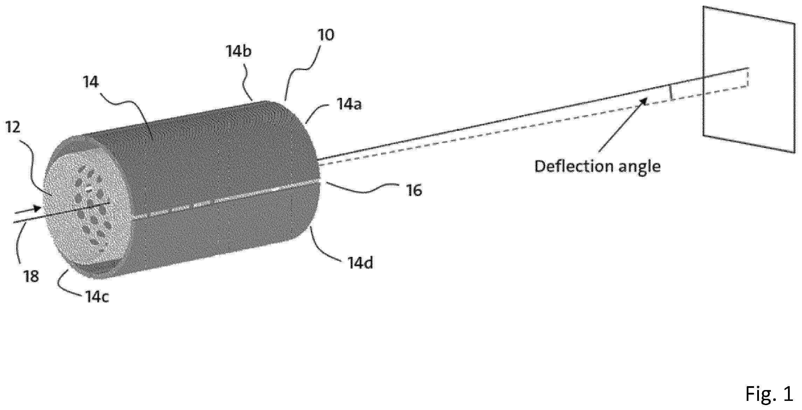

Figure 1 shows a deflector 10 having a central electrode 12 and four deflection electrodes 14. The central electrode 12 is of circular cylindrical shape with circular openings in the electrode wall. The deflection electrodes 14 are made of four identical segments each covering a quadrant and having a constant distance to the central electrode 12. Along the circumference of the deflection electrodes 14 there is an isolation slit 16 running in the longitudinal direction of the cylinder. The isolation slit 16 allows to provide every deflection electrode with a different potential. A particle beam 18 is traveling through a central electrode 12 along the longitudinal axis thereof. By applying an electric field having a component perpendicular to the longitudinal axis the particle beam is deflected. The deflection angle is measured with respect to the longitudinal axis.

Typically, the deflectors provide a defined electric field E at a fixed nominal potential in the electron-ion optical system. The nominal potential is a potential for the particular beam along the longitudinal axis within the central electrode.

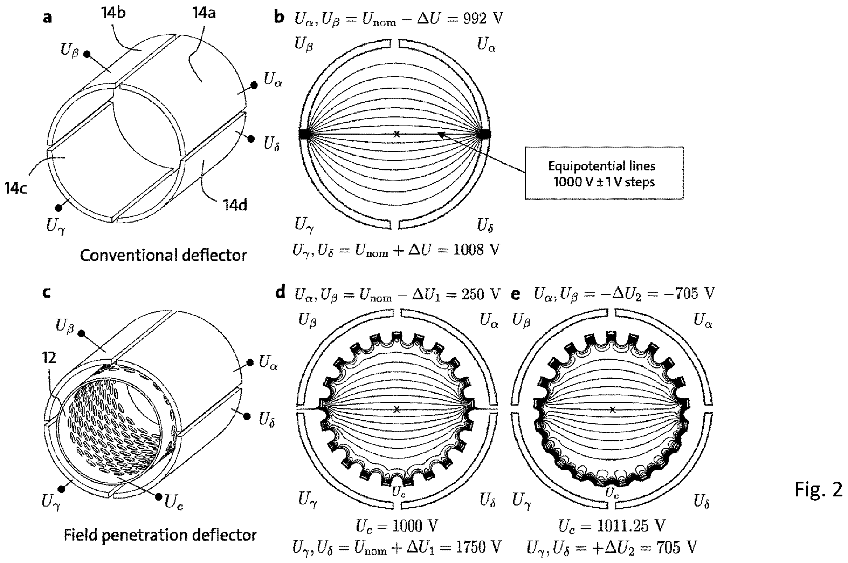

In case of a conventional deflector as shown in figure 2a individual potentials $U_\alpha$, $U_\beta$, $U_\gamma$, and $U_\delta$ are provided to the electrodes 14a, 14b, 14c and 14d. By supplying all the electrodes with the same potential, particles pass the electrodes without change of direction. With a symmetrical potential plus/minus $\Delta U_{supplied}$ to opposite deflection electrodes, an electric field is generated without changing the potential $U_{nom}$ in the centre of the electrodes. For the example, as defined in the introductory part, with two electrodes having the potential of 992 V and two electrodes having the potential of 1008 V, the equipotential lines of the field are shown in figure 2b. The beam of charged particles is deflected in the direction of the gradient of the equipotential lines.

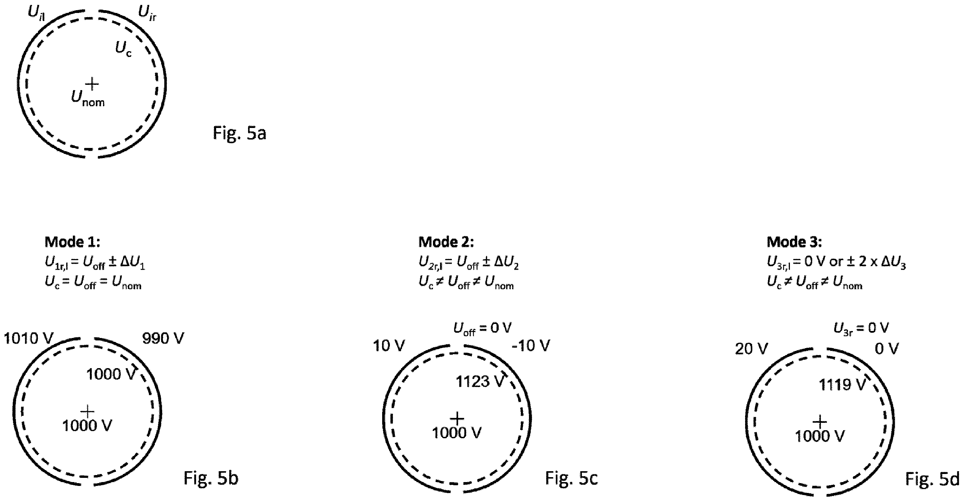

Figure 2c shows the invented field penetrating deflector having four electrodes 14a to 14d each having a potential $U_\alpha$, $U_\beta$, $U_\gamma$, and $U_\delta$. The central electrode 12 is provided with the central potential $U_c$ as shown in Figure 2c. As an example, according to operation mode 1 with a deflection potential $\Delta U_1$ = 750 V, in Figure 2d two of the deflection electrodes 14 a, b are provided with the potential of 250 V, while the other electrodes are provided with the potential of 1750 V. The central electrode is provided with a potential $U_c = U_{nom}$ of 1000 V. Due to the partial shielding by the perforated central electrode 12, in order to generate the same field strength as the conventional deflector (Fig. 2b) much higher antisymmetric potential differences are used (1500 V vs. 16 V). For the case of operation mode 2 with a deflection potential $\Delta U_2$ = 705 V, figure 2e shows a situation in which the same voltage magnitude is applied with opposite signs to the electrode pairs 14 a, b and 14 c, d, respectively. By supplying a potential $U_c$ of 1011.25 V to the central electrode 12, the same electric field strength is achieved as in figure 2d. In this example $U_{off}$ is chosen to be 0 V. Importantly, both operation modes discussed above in Fig. 2d and Fig. 2e are much more robust to voltage drifts or changes in the voltage level as the conventional configuration of Fig. 2b. A complete set of operation modes is discussed with respect to figure 5.

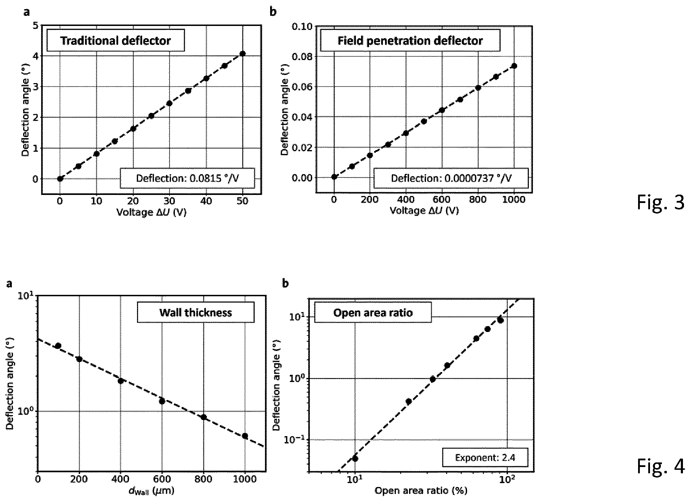

As indicated in figure 3 it is very interesting to compare a traditional deflector (without a central electrode) with the field penetrating deflector. The only mechanical modification is an additional central electrode. The deflection angle per voltage is extracted from a linear fit as shown in figures 3a, 3b. The deflection angle per voltage is the amount of angular deflection for a particle beam with respect to the applied potential difference 2 x |$\Delta U$| of opposite electrodes. Consequently, this factor is also indicative of a sensitivity on drifts or fluctuations in the supply voltage and thus for the angular stability of the deflector. Of course, the angle of deflection also depends on many other factors. Therefore, it is helpful to compare the angular deflection not on the basis of absolute values but rather of a ratio of deflection angles. This means the ratio of deflection per voltage can be compared by the quotient of the values. For example, as shown in figure 3, this ratio is about $10^3$ which is understood as an increase in the deflection stability by three orders of magnitude. The simulations in figure 3 were performed for a nominal potential of $U_{nom}$ = 1 kV and protons with 2 keV kinetic energy. The traditional deflector in figure 3a has 20 mm inner diameter and 45 mm length. The field penetrating deflector features a central electrode of 20 mm inner diameter, 0.75 mm wall thickness and 40 mm length perforated by a hexagonal pattern of holes with radius r = 0.75 mm and hole separation D = 3 mm.

Besides the value of the deflection per voltage it is also interesting which effect the wall thickness of the central electrode has on the deflection angle. Figure 4a shows on a logarithmic scale for the deflection angle that with increasing wall thickness the deflecting angle is reduced. This means the deflection angle reduces exponentially with increasing wall thickness Fig. 4b considers the effect of the open area ratio which is the ratio between the area of the openings within the wall of the central electrode and the total area. Here, the result of the double-logarithmic plot discloses a dependency of the deflection angle on the open area ratio according to a power-law with an exponent of about 2.4.

It is noted, that the detailed scaling displayed in figure 4 depend on the actually chosen geometry, including the form and distribution of the holes in the central electrode. The simulations presented in figure 4 were performed for a central electrode of 20 mm inner diameter, for 0.4 mm wall thickness (if not varied) and for 40 mm length perforated by a hexagonal pattern of holes with radius r = 1 mm (if not varied) and a hole separation D = 3 mm. The open area ratio OAR of such a pattern is given by $\mathrm{OAR} = 2\pi/\sqrt{3}\; {r^2}/{D^2}$ and is limited to the range of 0% (full shielding) to 90.69% $(\pi/2\sqrt{3})$ for $r = D/2$. The embodiment refers to a regular pattern of circular holes in the wall of the central electrode, however any other regular or even irregular pattern is possible as well as any other form for the hole is possible, e.g., stripes, squares, which are also well-suited forms for the effect of penetrating into the central electrode.

Three different modes of operation have already been discussed above. As indicated in figure 5a we consider one-dimensional steering by two deflector electrodes at potentials $U_1$ and $U_r$. The potential of the central electrode is indicated as $U_c$. Furthermore, figures 5b - 5d consider the same nominal potential $U_{nom}$, i.e., the nominal potential on the electrode axis as indicated by '+' in the centre of the central electrode. All three modes of operation are discussed below for the same nominal potential of 1 kV. The first mode of operation is defined as:

$$U_{1l,r} = U_{off} \pm \Delta U_1 \;;\; U_c = U_{off} = U_{nom}$$

Wherein $U_{off}$ defines an auxiliary offset potential for the deflecting electrodes. This means the potential of the deflecting electrode is centred around the offset potential and has a difference of $\pm\Delta U_1$ for the first mode of operation. Furthermore, in the first operation mode the nominal potential $U_{nom}$, the offset potential $U_{off}$ and the potential of the central electrode $U_c$ are equal.

The second mode of operation is defined

$$U_{2l,r} = U_{off} \pm \Delta U_2 \;;\; U_c \neq U_{off} \neq U_{nom} \;;\; U_{off} = 0$$

wherein of course the potential of the central electrode $U_c$ depends on the offset potential $U_{off}$. As shown for the example in the figure 5c, we have an offset potential $U_{off}$ = 0 V and voltage for the opposing electrodes of plus/minus 10 V. The potential of the central electrode $U_c$ is slightly higher than the nominal potential $U_{nom}$.

The third mode of operation can be considered as a special case of operation mode 2 wherein the offset potential is defined such that the potential of one electrode is set to zero. Expressed in equations

$$U_{3l} = 2 \times \Delta U_3 \;;\; U_{3r} = 0 \;;\; U_c \neq U_{off} \neq U_{nom}.$$

In this situation the offset potential (10 V in this example) is chosen such that one of the deflection electrodes is fixed to a value of 0 V. Again, the same nominal potential in the centre of the central electrode is achieved and the deflection of the beam is controlled by the potential of the remaining deflection electrode.

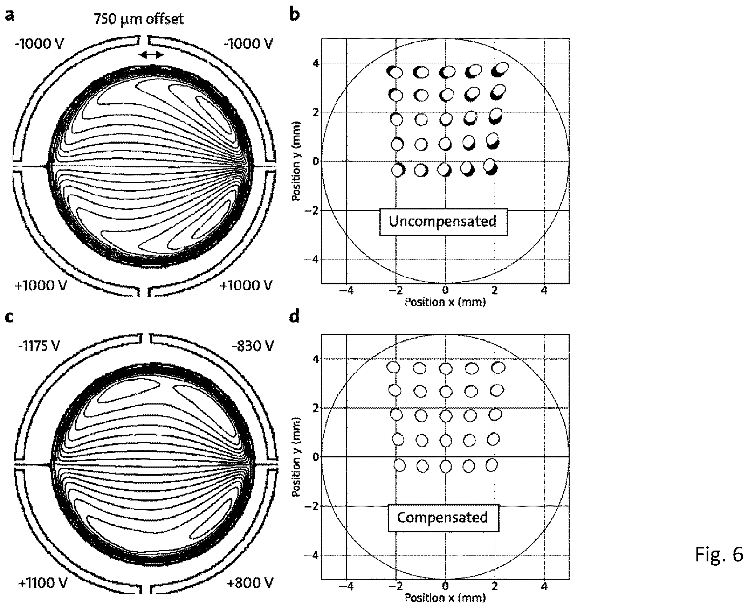

As indicated in figure 6a a slight geometrical offset in the central electrode for example by 750 $\mu$m leads to an asymmetric field configuration which introduces the distortion of the regular pattern for charged particles propagated through the deflector. As shown in figure 6b there is an increasing offset in the y direction and the configuration loses its regular shape.

As shown in figure 6c, by a correction of the voltage values a good compensation of the configuration can be achieved. For the same offset of the central electrode figure 6d shows the compensated regular pattern with less distortion in particular for large y-values. The centre of the central electrode and the deflector electrodes impacts the deflection of the charged particle beams. However, the possibility to compensate for field distortions introduced by the mechanical misalignment of the centre is possible with nonsymmetric electric potentials applied to the deflection electrodes.

## Claims

1. Electrostatic deflector for charged particle optics comprising at least two deflection electrodes connected to at least one power supply to supply a predefined potential ($U_i$) to at least one of the deflection electrodes, wherein the deflection electrodes define an axis of flight for a charged particle beam and provide an electrical field in a transverse direction to the axis of flight, **characterized in that** a central electrode encloses the axis of flight, wherein the central electrode has a plurality of openings through which the electrical field of the deflection electrodes penetrates into the central electrode and deflects the charged particle beam within the central electrode.

2. Electrostatic deflector according to claim 1, wherein the deflection electrodes enclose the central electrode.

3. Electrostatic deflector according to claim 1 or 2, wherein the central electrode is connected to a power supply for applying a predefined potential ($U_c$).

4. Electrostatic deflector according to one of the claims 1 to 3, wherein the at least two deflection electrodes form a cylinder with the particle beam traveling parallel along a longitudinal axis of the cylinder, wherein the cylinder preferably forms a circular cylinder.

5. Electrostatic deflector according to one of the claims 1 to 4, wherein the at least two deflection electrodes have the same size and form to cover all four quadrants around the central electrode.

6. Electrostatic deflector according to one of the claims 1 to 5, wherein for a nominal potential ($U_{nom}$) along the longitudinal axis in a first mode of operation, equal electrode offset potentials ($U_{off}$) for the at least two deflection electrodes are supplied to opposing deflection electrodes together with an additional potential (+/- $\Delta U_1$), such that at least one of the opposing deflection electrodes is supplied with a total potential of the electrode offset potential ($U_{off}$) plus the additional potential (+ $\Delta U_1$) and the at least one opposite deflection electrode is supplied with a total potential of the electrode offset potential ($U_{off}$) minus the additional potential (- $\Delta U_1$).

7. Electrostatic deflector according to claim 6, wherein in the first mode of operation the central electrode is supplied with a central potential ($U_c$) which is in this case equal to the electrode offset potential ($U_{off}$).

8. Electrostatic deflector according to claim 6 or 7, wherein the electrode offset potential ($U_{off}$) of the at least two deflection electrodes correspond to the nominal potential ($U_{nom}$) along the longitudinal axis.

9. Electrostatic deflector according to one of the claims 1 to 8 or 6, wherein in a second mode of operation the offset potential ($U_{off}$) is chosen to be 0 V and opposite electrode potentials (+/- $\Delta U_2$) are supplied to opposing deflection electrodes, such that one of the opposing deflection electrodes is supplied with a positive electrode potential (+ $\Delta U_2$) while the opposite deflection electrode is supplied with a negative electrode potential (- $\Delta U_2$).

10. Electrostatic deflector according to claim 9, wherein in the second mode of operation the central electrode is supplied with a central potential ($U_c$), the modulus of which is preferably greater than the modulus of the electrode offset potential ($U_{off}$) of the at least two deflection electrodes.

11. Electrostatic deflector according to one of the previous claims, wherein in a third mode of operation, the offset potential ($U_{off}$) is defined such that at least one of the electrode potentials ($U_i$ = 0 V) is zero while the opposing electrode is supplied with a deflection potential +/- 2 x $\Delta U_3$.

12. Electrostatic deflector according to one of the previous claims, wherein the central electrode has a predetermined cylindrical geometry comprising at least one of the following features: an inner diameter, a wall thickness and an open area ratio such that a predefined deflection angle per voltage is achieved.

13. Electrostatic deflector according to one of the claims 1 to 12, wherein the ratio of deflection per voltage [°/V] with and without central electrode is more than $10^2$, preferably more than $10^3$.

14. Electrostatic deflector according to one of the previous claims, wherein a compensation voltage ($\Delta U/_{comp}$) is applied to at least one of the deflection electrodes, such that an off-centre position of the central electrode within the deflection electrode is compensated for a particle beam passing the central electrode.

Fig. 1

**a**  14b  14a

$U_\beta$

$U_\alpha$

$U_\delta$

14c

$U_\gamma$  14d

Conventional deflector

**b** $U_\alpha, U_\beta = U_{\text{nom}} - \Delta U = 992$ V

$U_\beta$  $U_\alpha$

Equipotential lines
1000 V ± 1 V steps

$U_\gamma$  $U_\delta$

$U_\gamma, U_\delta = U_{\text{nom}} + \Delta U = 1008$ V

**c**

$U_\beta$

12

$U_\alpha$

$U_\delta$

$U_\gamma$  $U_c$

Field penetration deflector

**d** $U_\alpha, U_\beta = U_{\text{nom}} - \Delta U_1 = 250$ V

$U_\beta$  $U_\alpha$

$U_\gamma$  $U_\delta$

$U_c = 1000$ V

$U_\gamma, U_\delta = U_{\text{nom}} + \Delta U_1 = 1750$ V

**e** $U_\alpha, U_\beta = -\Delta U_2 = -705$ V

$U_\beta$  $U_\alpha$

$U_\gamma$  $U_\delta$

$U_c = 1011.25$ V

$U_\gamma, U_\delta = +\Delta U_2 = 705$ V

Fig. 2

EP 4 303 907 A1

Fig. 3

Fig. 4

$U_{il}$   $U_{ir}$

$U_c$

$U_{nom}$ +

Fig. 5a

**Mode 1:**
$U_{1r,l} = U_{off} \pm \Delta U_1$
$U_c = U_{off} = U_{nom}$

1010 V   990 V

1000 V

+
1000 V

Fig. 5b

**Mode 2:**
$U_{2r,l} = U_{off} \pm \Delta U_2$
$U_c \neq U_{off} \neq U_{nom}$

$U_{off} = 0\ V$
10 V   -10 V

1123 V

+
1000 V

Fig. 5c

**Mode 3:**
$U_{3r,l} = 0\ V$ or $\pm 2 \times \Delta U_3$
$U_c \neq U_{off} \neq U_{nom}$

$U_{3r} = 0\ V$
20 V   0 V

1119 V

+
1000 V

Fig. 5d

Fig. 6

Europäisches
Patentamt

European
Patent Office

Office européen
des brevets

# EUROPEAN SEARCH REPORT

Application Number

EP 22 18 3392

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 771 019 B1 (HITACHI LTD [JP]) 20 August 2003 (2003-08-20) | 1-3 | INV.<br>H01J37/147<br>H01J1/00<br>H01J49/00 |
| A | * paragraphs [0026], [0037]; figure 2 *<br>----- | 4-14 | |

TECHNICAL FIELDS
SEARCHED      (IPC)

H01J

The present search report has been drawn up for all claims

| Place of search | Date of completion of the search | Examiner |
|---|---|---|
| Munich | 19 December 2022 | Oestreich, Sebastian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................................
& : member of the same patent family, corresponding
    document

EPO FORM 1503 03.82 (P04C01)

**EP 4 303 907 A1**

## ANNEX TO THE EUROPEAN SEARCH REPORT
## ON EUROPEAN PATENT APPLICATION NO.

EP 22 18 3392

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2022

| Patent document cited in search report | | Publication date | Patent family member(s) | | Publication date |
|---|---|---|---|---|---|
| EP 0771019 | B1 | 20-08-2003 | DE | 69629536 T2 | 08-04-2004 |
| | | | EP | 0771019 A1 | 02-05-1997 |
| | | | JP | 3620120 B2 | 16-02-2005 |
| | | | JP | H09127060 A | 16-05-1997 |

EPO FORM P0459

For more details about this annex : see Official Journal of the European Patent Office, No. 12/82

14

**EP 4 303 907 A1**

**REFERENCES CITED IN THE DESCRIPTION**

**Patent documents cited in the description**

- US 10796893 B2
- DE 112008003955 B4
- JP S57202630 A
- JP S61142646 B